# FASCICULE DE BREVET EUROPEEN

(11) **EP 4 062 463 B1**
(45) Date de publication et mention de la délivrance du brevet: **03.01.2024**
(21) Numéro de dépôt: 20807388.2
(22) Date de dépôt: 17.11.2020
(51) Int. Cl.: H10N 70/00

(54) **CELLULE MÉMOIRE DE TYPE OXRAM À FAIBLE TENSION DE FORMING, ET PROCÉDÉ DE FABRICATION ASSOCIÉ**
OXRAM-SPEICHERZELLE MIT NIEDRIGER FORMBILDUNGSSPANNUNG UND ZUGEHÖRIGES HERSTELLUNGSVERFAHREN
LOW FORMING VOLTAGE OXRAM MEMORY CELL, AND ASSOCIATED METHOD OF MANUFACTURE

(30) Priorité: 21.11.2019 FR 1912999
(43) Date de publication de la demande: 28.09.2022
(73) Titulaire: Commissariat à l'Energie Atomique et aux Energies Alternatives, 75015 Paris (FR); Weebit Nano Ltd, 4527713 Hod-HaSharon (IL)
(72) Inventeur: MOLAS, Gabriel, 38054 Grenoble Cedex 09 (FR); MAGIS, Thomas, 38054 Grenoble Cedex 09 (FR); NODIN, Jean-François, 38054 Grenoble Cedex 09 (FR); BRICALLI, Alessandro, 38000 Grenoble (FR); PICCOLBONI, Guiseppe, 37124 Verona (IT); COHEN, Yifat, Kiryat Tivon (IL); REGEV, Amir, 71708 Modiin (IL)
(74) Mandataire: Cabinet Camus Lebkiri
(86) Numéro de dépôt international: PCT/EP2020/082390
(87) Numéro de publication internationale: WO 2021/099309

(56) Documents cités:
- WO-A1-2019/055052
- US-A1- 2014 264 231
- US-A1- 2017 170 394

## Description

### DOMAINE TECHNIQUE DE L'INVENTION

Le domaine technique de l'invention est celui de la micro-électronique, plus particulièrement celui des mémoires non volatiles résistives de type filamentaire.

La présente invention concerne plus particulièrement une cellule mémoire résistive à base d'oxyde, de type OxRAM (selon l'acronyme anglo-saxon de « Oxide-based résistive Random Access Memory ») ainsi qu'un procédé de fabrication d'une telle cellule.

### ARRIERE-PLAN TECHNOLOGIQUE DE L'INVENTION

De nouveaux types de mémoires non volatiles, appelées mémoires résistives, ou parfois ReRAM (selon l'acronyme de « Resistive Random Access Memory »), ont été développés ces dernières années. Une mémoire de ce type comprend différentes cellules mémoires, parfois appelées « points mémoire », stockant chacune une donnée binaire. La donnée binaire en question est représentée par le niveau de résistance, soit haut, soit bas, de la cellule mémoire considérée.

Une telle cellule mémoire est généralement fabriquée en réalisant un empilement de plusieurs couches, cet empilement comprenant une électrode inférieure, une électrode supérieure, et une couche active qui s'étend entre l'électrode inférieure et l'électrode supérieure. L'empilement en question, dont les dimensions latérales sont initialement importantes, est gravé pour obtenir plusieurs cellules mémoires distinctes les unes des autres (cette gravure permet de délimiter latéralement chaque cellule mémoire). Ce sont généralement l'électrode supérieure et la couche active qui sont gravées afin de définir les dimensions latérales de la partie « active » de chaque cellule mémoire (c'est-à-dire de la partie où est enregistrée la donnée à stocker). Un exemple de l'art antérieur se trouve dans le document US2017/0170394 qui divulgue une cellule mémoire de type OxRAM.

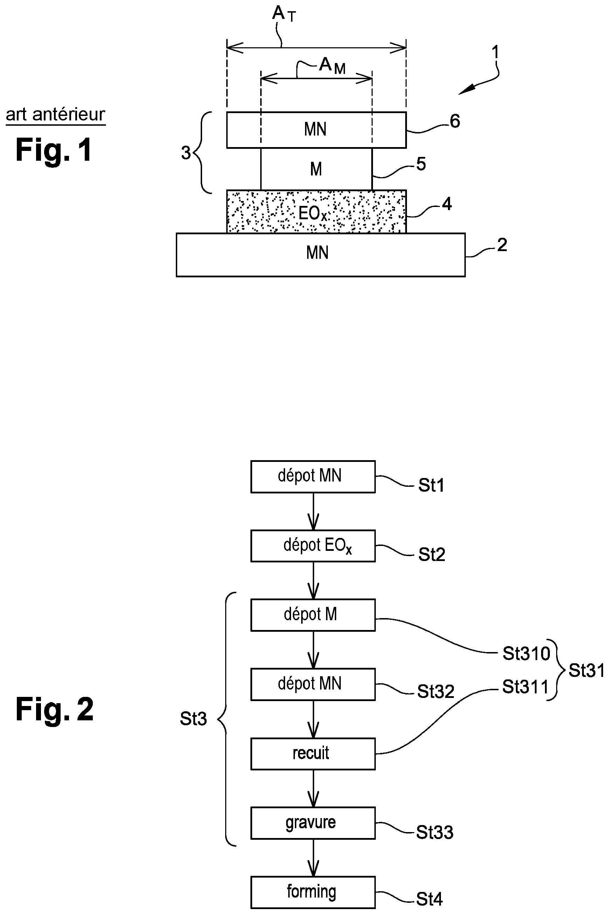

Dans une cellule mémoire de type OxRAM, telle que la cellule 1 représentée sur la figure 1, la couche active 4 est formée d'un oxyde métallique ou d'un oxyde de semi-conducteur, EOx, par exemple un oxyde d'Hafnium ou de Silicium. Initialement, la couche active 4 est complètement isolante électriquement. Mais une étape appelée « forming » est réalisée ensuite, pour chaque cellule mémoire. Au cours de cette étape, un filament électriquement conducteur est formé dans la couche active, en réalisant une sorte de claquage contrôlé de cette couche. Le filament ainsi formé s'étend alors de part en part à travers la couche active, en reliant électriquement l'électrode inférieure 2 et l'électrode supérieure 3.

Pour réaliser cette étape de forming, on peut par exemple appliquer une tension électrique entre l'électrode inférieure et l'électrode supérieure de la cellule mémoire considérée, puis augmenter progressivement la valeur de cette tension jusqu'à une tension seuil, appelée tension de forming U_{F}, au-delà de laquelle un claquage de la couche active est obtenu.

Une fois formé, le filament conducteur peut être rompu, puis reformé, puis rompu à nouveau et ainsi de suite, au cours de cycles successifs d'écriture (SET) puis de remise à zéro (RESET), c'est-à-dire d'effacement de la cellule mémoire (opérations de SET, lorsque le filament est reformé, et de RESET, lorsque le filament est rompu à nouveau). Les tensions seuils à appliquer à la cellule mémoire pour rompre le filament et pour le former à nouveau (tensions de RESET et de SET), sont généralement plus faibles que la tension de forming U_{F}, nécessaire pour former le filament la première fois.

Le mécanisme de formation du filament peut impliquer une réorganisation de lacunes en oxygène, au sein de l'oxyde qui forme la couche active. Aussi, pour faciliter cette réorganisation, on intègre généralement une couche réservoir 5, apte à stocker de l'oxygène, dans l'électrode supérieure 3. Cette couche réservoir, qui s'étend au-dessus de la couche active 4, contre celle-ci, est le plus souvent formée d'un métal M (non oxydé) tel que du Titane, du Lanthane, ou encore du Zirconium. La couche réservoir 5 est généralement recouverte d'une couche de protection 6, par exemple en nitrure MN du métal en question.

En pratique, il est intéressant de graver des cellules mémoires ayant des dimensions transverses réduites, pour augmenter la densité d'informations stockées dans la mémoire.

Mais on constate en pratique que la tension de forming U_{F}, qu'il faut appliquer pour créer le filament conducteur la première fois, augmente lorsque la section de la cellule mémoire diminue. Cette augmentation est assez progressive pour des sections allant de 1 µm² à 100×100 nm² environ. En dessous d'une centaine de nanomètre de côté environ, on observe en revanche une augmentation rapide de la tension de forming U_{F}, lorsque la section de la cellule mémoire diminue (plus précisément, lorsque l'aire de l'électrode supérieure diminue). Cette augmentation conduit alors à des valeurs de tension de forming U_{F} élevées, par exemple supérieures à 5 ou 6 volts, nettement plus grandes que les tensions de SET et RESET de la cellule mémoire, qui sont typiquement inférieures à 1, ou 2 volts.

Pour pouvoir réaliser l'opération de forming, la puce qui accueille la mémoire doit alors être équipée d'une électronique supplémentaire dédiée spécifiquement à l'opération de forming, permettant de délivrer des tensions électriques élevées (en plus de l'électronique de pilotage des cellules mémoire, qui permet de réaliser les opérations de SET et RESET). Cette électronique supplémentaire augmente alors le coût de fabrication de la mémoire, et les dimensions qu'elle occupe sur la puce électronique.

Il serait donc utile de réduire la tension de forming U_{F} de telles cellules mémoire, sans pour autant augmenter la surface qu'occupe chacune de ces cellules.

### RESUME DE L'INVENTION

Dans ce contexte, l'invention propose une cellule mémoire résistive de type OxRAM qui comporte une couche réservoir d'un type particulier, grâce à laquelle la tension de forming U_{F} de la cellule peut être réduite, sans pour autant augmenter la surface qu'occupe la cellule.

Plus particulièrement, l'invention propose une cellule mémoire résistive de type OxRAM comprenant une électrode inférieure, une électrode supérieure, et une couche active qui s'étend entre l'électrode inférieure et l'électrode supérieure, la couche active comprenant au moins une couche d'un premier oxyde électriquement isolant, dans lequel un filament électriquement conducteur peut être formé, puis ultérieurement rompu et formé à nouveau plusieurs fois successivement, l'électrode supérieure comprenant une couche réservoir apte à accueillir de l'oxygène, une partie au moins de la couche réservoir étant formée d'un métal, dans laquelle ladite couche réservoir comprend une partie supérieure formée par ledit métal et une partie inférieure formée par un deuxième oxyde, le deuxième oxyde étant un oxyde dudit métal et comportant une proportion d'oxygène telle que le deuxième oxyde est électriquement conducteur, avec une conductivité électrique supérieure à 100 Siemens par mètre.

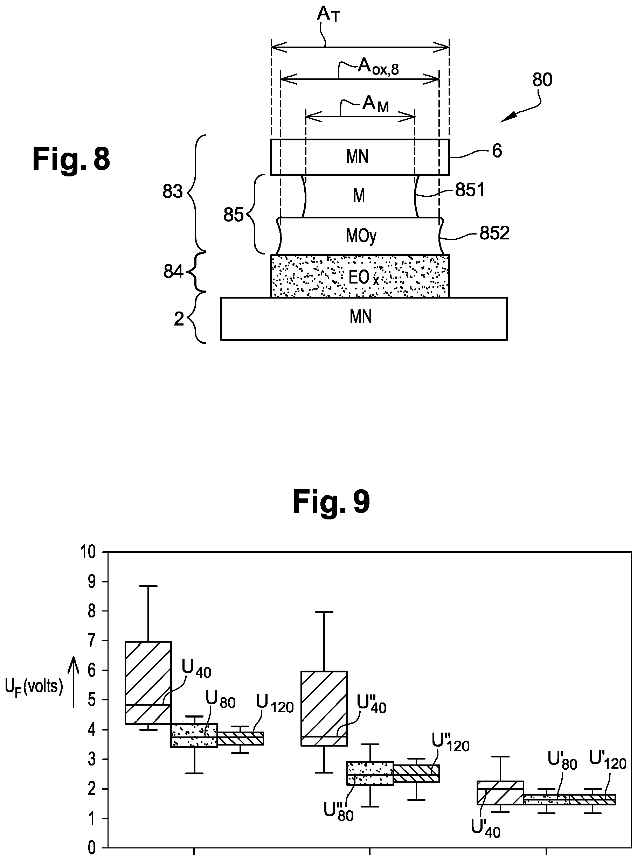

Les inventeurs ont constaté que la partie inférieure de la couche réservoir, formée du deuxième oxyde conducteur, permet de réduire notablement la tension de forming U_{F} de la cellule mémoire par rapport à une cellule mémoire de mêmes dimensions externes mais dépourvue de cette partie en oxyde conducteur (la diminution de la tension de forming en question est illustrée sur la figure 9, à titre d'exemple, pour un premier type de cellule mémoire conforme aux enseignements de l'invention).

Une explication de l'amélioration apportée par cette couche réservoir particulière est présentée ci-dessous, après avoir discuté des mécanismes pouvant être responsables des valeurs de tension de forming U_{F} élevées, habituellement obtenues pour des cellules de faible section.

Tout d'abord, on pourra remarquer que l'opération de « forming » est basée sur un mécanisme de claquage contrôlé de l'oxyde EOx de la couche active 4. Ce claquage est lié à la formation de défauts dans la couche active, défauts qui entrainent la formation d'un chemin conducteur. Or cette formation de défauts est d'autant plus probable que la section transverse de la cellule est grande. Autrement formulé, plus la section de la cellule est petite, et moins il y a d'emplacements propices pour déclencher, ou autrement dit, pour amorcer le claquage en question, si bien qu'une tension électrique plus important est alors nécessaire pour obtenir le claquage.

Cet effet est accentué par la gravure latérale de la cellule mémoire, plus ou moins marquée selon la couche considérée. En effet, dans une cellule de l'art antérieur telle que celle représentée sur la figure 1, la couche réservoir 5, formée entièrement par le métal M, est moins résistante à la gravure que les autres couches de la mémoire (en nitrure dudit métal, MN, ou en oxyde EOx). Après gravure, la couche réservoir 5 a donc une section plus petite que la couche active 4 et que la face supérieure de la cellule mémoire. Cette gravure latérale plus marquée pour la couche en métal 5, parfois appelée « undercut » en anglais (ou encore « notching »), est représentée schématiquement sur la figure 1. Pour des cellules de grande section, la réduction de section de la couche réservoir 5 due à cette gravure différentielle reste faible, en valeur relative. En revanche, pour une cellule mémoire de petites dimensions, par exemple une cellule de 40 nm de côté, cet effet d'« undercut » peut rendre l'aire A_{M} de la section de la couche réservoir 5 presque quatre fois plus petite que l'aire A_{T} de la face supérieure de la cellule mémoire.

Le potentiel électrique, appliqué sur la face supérieure de la couche active 4 pour obtenir le claquage de cette couche, est donc finalement appliqué (via la couche réservoir 5) sur une surface effective A_{M} qui est nettement plus petite que la surface apparente A_{T} occupée par la cellule mémoire (surface apparente qui est d'ailleurs elle-même petite). Cela explique les valeurs de tension de forming particulièrement élevées observées pour les cellules mémoires dont la face supérieure a une aire de l'ordre de 100×100 nm² ou moins.

La structure particulière de la couche réservoir employée dans la cellule mémoire conforme à l'invention permet de s'affranchir au moins partiellement de la réduction de section (c'est-à-dire de l'« undercut ») décrite ci-dessus, ce qui permet d'abaisser la tension de forming de la cellule.

En effet, pour les métaux utilisés habituellement comme couche réservoir, par exemple le Titane, le Lanthane, ou encore le Zirconium, l'enthalpie de formation correspondant à une liaison métal-métal M-M est inférieure à celle correspondant à une liaison métal-oxygène M-O. D'ailleurs, la liaison métal-oxygène M-O en question a même une enthalpie de formation supérieure à celle d'une liaison métal-Chlore M-CI (Chlore qui est fréquemment utilisé comme agent de gravure par plasma, lors de la fabrication de ce type de mémoires).

Dans une cellule mémoire conforme à l'invention, le deuxième oxyde MOy est donc a priori plus résistant à la gravure, en particulier à une gravure par plasma halogéné, que le métal M lui-même. Et l'on constate d'ailleurs en pratique que l'«undercut » de la couche réservoir est plus faible pour la partie en oxyde MOy que pour la partie en métal M.

Grâce à sa partie en oxyde conducteur MOy, cette couche réservoir présente donc après gravure, sous le métal M, une zone électriquement conductrice et dont la section transverse est plus grande que ce qui aurait été obtenu avec une couche formée seulement du métal M. La couche réservoir particulière employée ici permet donc à la fois :
- d'obtenir l'effet souhaité de « réservoir à oxygène », grâce à sa partie supérieure formée dudit métal, et
- d'appliquer un potentiel électrique donné sur la face supérieure de la couche active, sur une surface effective plus grande que l'aire A_{M} de la section de la partie supérieure en métal (grâce au caractère à la fois conducteur et résistant à la gravure du deuxième oxyde MOy).

La conductivité électrique relativement élevée de la partie en oxyde métallique conducteur, supérieure à 100 Siemens par mètre, permet d'exploiter effectivement l'essentiel de la section de cette partie en oxyde métallique (section avantageusement plus grande que celle de la partie en métal M) pour appliquer le potentiel électrique en question à la face supérieure de la couche active.

La couche réservoir particulière employée ici permet ainsi, pour une aire A_{T} donnée de la face supérieure de la cellule mémoire, et donc pour un encombrement donné de la cellule mémoire, de réduire la tension de forming U_{F}, par rapport à une cellule de l'art antérieur, telle que celle représentée sur la figure 1, par exemple.

Outre les caractéristiques qui viennent d'être évoquées dans le paragraphe précédent, la cellule mémoire selon un aspect de l'invention peut présenter une ou plusieurs caractéristiques complémentaires optionnelles parmi les suivantes, considérées individuellement ou selon toutes les combinaisons techniquement possibles :
- la couche réservoir comprend une proportion d'oxygène qui varie progressivement depuis la partie inférieure de la couche réservoir jusqu'à sa partie supérieure ;
- la partie inférieure de la couche réservoir est formée par une première sous-couche formée dudit deuxième oxyde, et la partie supérieure de la couche réservoir est formée par une deuxième sous-couche, distincte de la première sous-couche et formée dudit métal ;
- la cellule ayant été délimitée latéralement par gravure, dans laquelle la partie inférieure de la couche réservoir, formée du deuxième oxyde, a une section plus grande que la section de la partie supérieure de la couche réservoir, formée dudit métal, par exemple au moins 20% plus grande ;
- ledit métal est l'un des métaux suivants : Le Titane, le Tantale, le Gadolinium, le Lanthane, l'Aluminium, le Zirconium, l'Hafnium ;
- le premier oxyde est un oxyde d'un élément chimique différent dudit métal ;
- ledit métal est du Titane et dans laquelle la proportion d'oxygène dans le deuxième oxyde est inférieure à 1,7 atomes d'oxygène par atome de Titane ;
- le premier oxyde est un oxyde de Silicium ;
- une face supérieure de la cellule mémoire a une aire inférieure à 1 micron carré, voire inférieure à 0,1 micron carré ou même inférieure à 0,01 micron carré.

Un autre aspect de l'invention concerne un procédé de fabrication d'une cellule mémoire résistive de type OxRAM, comprenant les étapes suivantes :
- déposer une électrode inférieure, puis
- déposer une couche active sur l'électrode inférieure, la couche active comprenant au moins une couche formée d'un premier oxyde, le premier oxyde étant électriquement isolant et étant apte à servir de support à la formation d'un filament électriquement conducteur traversant ledit premier oxyde, le filament pouvant être rompu puis formé à nouveau plusieurs fois successivement, puis
- produire une électrode supérieure recouvrant la couche active, en exécutant les étapes suivantes :
   - produire une couche réservoir apte à accueillir de l'oxygène, une partie au moins de la couche réservoir étant formée d'un métal, et
   - graver l'électrode supérieure de manière à délimiter latéralement la cellule mémoire, l'étape de gravure étant réalisée après l'étape de production de ladite couche réservoir,
- dans lequel l'étape de production de la couche réservoir est réalisée de manière à ce que la couche réservoir comprenne une partie supérieure formée par ledit métal, et une partie inférieure formée par un deuxième oxyde, le deuxième oxyde étant un oxyde dudit métal comportant une proportion d'oxygène telle que le deuxième oxyde est électriquement conducteur, avec une conductivité électrique supérieure à 100 Siemens par mètre.

Outre les caractéristiques qui viennent d'être évoquées dans le paragraphe précédent, la cellule mémoire selon un aspect de l'invention peut présenter une ou plusieurs caractéristiques complémentaires parmi les suivantes, considérées individuellement ou selon toutes les combinaisons techniquement possibles :
- l'étape de production de la couche réservoir comprend les sous-étapes suivantes :
   - déposer une couche dudit métal sur la couche active, puis
   - réaliser un recuit à une température et pendant une durée telles que la couche précédemment déposée comprenne, après recuit : ladite partie supérieure formée par ledit métal, ainsi que ladite partie inférieure formée par le deuxième oxyde électriquement conducteur ;
- l'étape de production de la couche réservoir comprend les sous-étapes suivantes :
   - déposer une première sous-couche sur la couche active, la première sous-couche étant formée du deuxième oxyde, puis
   - déposer une deuxième sous-couche sur la première sous-couche, la deuxième sous-couche étant formée dudit métal ;
- la sous-étape de dépôt de la première sous-couche est réalisée par pulvérisation cathodique à partir d'une cible formée dudit deuxième oxyde électriquement conducteur ;
- la sous-étape de dépôt de la première sous-couche est réalisée par pulvérisation cathodique à partir d'une cible formée dudit métal, sous une atmosphère comprenant de l'oxygène, la pression partielle d'oxygène dans ladite atmosphère étant telle que la première sous-couche déposée soit formée par ledit deuxième oxyde, avec ladite proportion en oxygène ;
- l'étape de gravure est une gravure par plasma halogéné ;
- ledit plasma est un plasma de dichlore et/ou de bromure d'hydrogène.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
[Fig. 1] La figure 1 est une représentation schématique d'une cellule mémoire résistive de type OxRAM de l'art antérieure, vue de côté.
[Fig. 2] La figure 2 représente schématiquement différentes étapes d'un premier procédé de fabrication d'une cellule mémoire résistive de type OxRAM, conforme aux enseignements de l'invention.
[Fig. 3] La figure 3 représente schématiquement un premier type de cellule mémoire résistive de type OxRAM conforme aux enseignements de l'invention, réalisée grâce au procédé de la figure 2, à un stade intermédiaire de sa fabrication.
[Fig. 4] La figure 4 représente schématiquement la cellule mémoire de la figure 3, à un stade plus avancé de sa fabrication.
[Fig. 5] La figure 5 représente schématiquement la cellule mémoire de la figure 3, une fois gravée.
[Fig. 6] La figure 6 représente schématiquement une variante de la cellule mémoire de la figure 5.
[Fig. 7] La figure 7 représente schématiquement différentes étapes d'un deuxième procédé de fabrication d'une cellule mémoire résistive de type OxRAM, conforme aux enseignements de l'invention.
[Fig. 8] La figure 8 représente schématiquement un deuxième type de cellule mémoire résistive de type OxRAM conforme aux enseignements de l'invention, réalisée grâce au procédé de la figure 7.
[Fig. 9] La figure 9 montre des valeurs de tension de forming obtenues pour des cellules mémoires de l'art antérieur, telles que celle de la figure 1, et pour des cellules mémoires conformes aux enseignements de l'invention, obtenues grâce au procédé de la figure 2.
[Fig. 10] La figure 10 montre les valeurs d'une résistance basse et d'une résistance haute d'une cellule mémoire de l'art antérieur, telle que celle de la figure 1, obtenues au cours de plusieurs cycles successifs d'écriture et d'effacement de la cellule mémoire.
[Fig. 11] La figure 11 montre les valeurs d'une résistance basse et d'une résistance haute d'une cellule mémoire conforme aux enseignements de l'invention, obtenues au cours de plusieurs cycles successifs d'écriture et d'effacement de la cellule mémoire.

### DESCRIPTION DETAILLEE

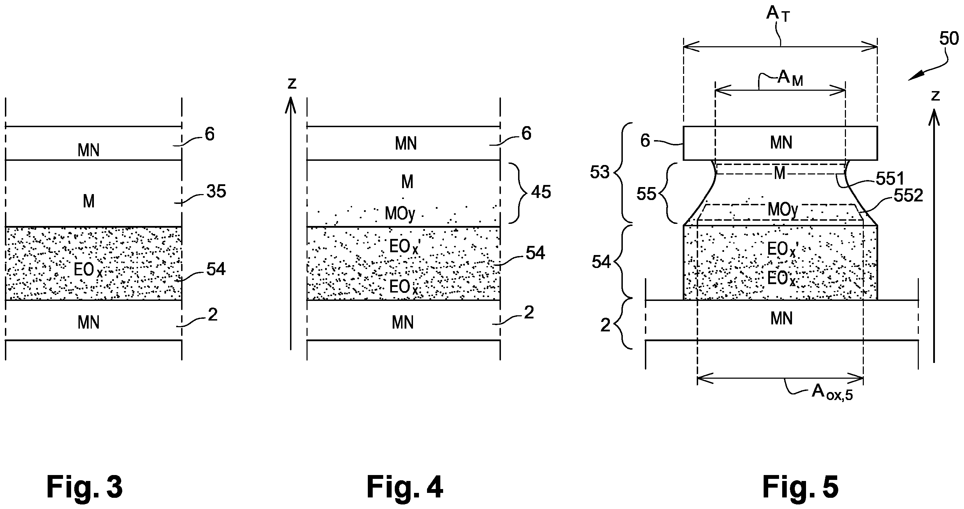

Comme déjà indiqué, l'invention concerne une cellule mémoire résistive de type OxRAM, comprenant une électrode inférieure 2, une électrode supérieure 53 ; 63 ; 83, et une couche active 54 ; 64 ; 84 qui s'étend entre l'électrode inférieure et l'électrode supérieure (voir les figures 5, 6 et 8).

La couche active 54 ; 64 ; 84 comprend au moins une couche d'un premier oxyde EOx, électriquement isolant. Ce premier oxyde EOx est apte à servir de support à la formation d'un filament électriquement conducteur, qui traverse la couche active de part en part pour relier électriquement l'électrode inférieure à l'électrode supérieure, et qui peut être rompu puis formé à nouveau plusieurs fois successivement au cours des cycles successifs d'écriture et d'effacement (RESET), c'est-à-dire de remise à zéro, de la mémoire. Comme expliqué en préambule, ce filament conducteur est produit une première fois lors d'une sorte de claquage électrique contrôlé de la couche active (opération de « forming »).

Le premier oxyde EOx mentionné ci-dessus est un oxyde métallique ou un oxyde de semi-conducteur, stoechiométrique ou sous-stoechiométrique. Il s'agit d'un oxyde d'un élément chimique E qui peut donc être un métal ou un semi-conducteur et qui peut par exemple être choisi parmi : l'Hafnium Hf, le Zirconium Zr, le Titane Ti, le Tantale Ta, le Niobium Nb, le Vanadium V, le Tungstène W, le molybdène Mo, l'Aluminium Al, le Gadolinium Gd, ou le Silicium Si.

La couche active peut être formée d'une même couche isolante, en oxyde EOx (cas de la couche active 84 de la figure 8).

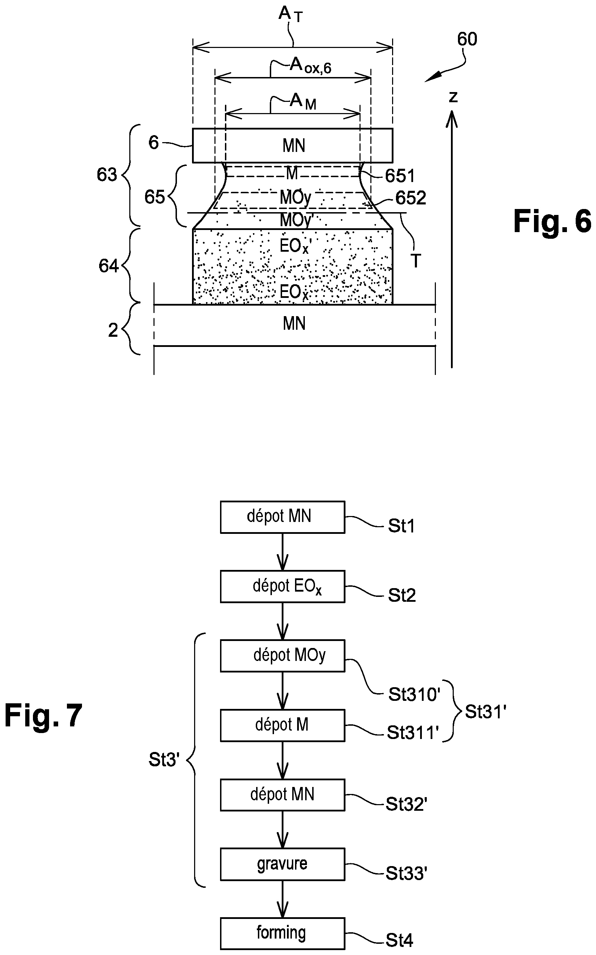

La couche active peut aussi être formée, en partie inférieure, par le premier oxyde EOx, et, en partie supérieure, par un oxyde EOx' du même élément chimique E, mais avec une teneur x' en oxygène plus faible que dans le premier oxyde EOx (cas des figures 5 et 6)

En variante, la couche active pourrait aussi être formée par un empilement de plusieurs sous-couches isolantes, formée d'oxydes de différents éléments choisis dans la liste indiquée ci-dessus. A titre d'exemple, cet empilement pourrait comprendre une sous-couche d'oxyde d'Hafnium HfOx, et, par-dessus, une sous-couche d'oxyde d'aluminium Al₂O_{z}. Dans le cadre de cette variante, l'une des sous-couches de l'empilement en question est alors formée du premier oxyde EOx.

Le mécanisme de formation du filament conducteur, dans la couche en oxyde EOx, implique généralement une réorganisation de lacunes en oxygène, au sein de cet oxyde. Pour faciliter cette réorganisation, l'électrode supérieure 53 ; 63 ; 83 comprend une couche réservoir 55 ; 65 ; 85 apte à accueillir de l'oxygène (parfois appelée « getter » en anglais). Une partie au moins de cette couche réservoir 55 ; 65 ; 85 est formée d'un métal M (pas ou peu oxydé) qui peut être du Titane Ti, du Lanthane, de l'Aluminium, du Zirconium, du Gadolinium, du Tantale ou de l'Hafnium. De préférence, le métal M est du Titane Ti, particulièrement bien adapté pour réaliser une telle couche réservoir.

La couche réservoir 55 ; 65 ; 85 s'étend au-dessus de la couche active 54 ; 64 ; 84 en la recouvrant. Ici, la couche réservoir s'étend directement sur la couche active 54 ; 64 ; 84, contre celle-ci, sans couche intermédiaire entre elles (ce qui facilite les échanges d'oxygène entre ces deux couches). En variante, une ou plusieurs couches intermédiaires, au moins partiellement perméables à l'oxygène, pourraient être intercalées entre la couche active et la couche réservoir.

L'électrode supérieure 53 ; 63 ; 83 peut, comme ici, comprendre une ou plusieurs couches supplémentaires, en plus de la couche réservoir 55 ; 65 ; 85.

En l'occurrence, l'électrode supérieure 53 ; 63 ; 83 comprend ici une couche supérieure 6, qui recouvre la couche réservoir 55 ; 65 ; 85 (voir les figures 5, 6 et 8). La couche supérieure 6 joue à la fois le rôle d'une couche de protection (empêchant notamment une oxydation totale de la couche réservoir), et le rôle d'une couche de contact permettant de raccorder électriquement la cellule mémoire à son circuit électronique de pilotage et de lecture. La couche supérieure 6 est plus résistante à la gravure que la partie de la couche réservoir 55 ; 65 ; 85 formée du métal M. La couche supérieure 6 est formée ici d'un nitrure MN du métal M mentionné plus haut (cette couche supérieure peut donc être formée, par exemple, par du nitrure de Titane TiN).

L'électrode inférieure 2, déposée sur un substrat (non représenté), comprend une couche métallique neutre vis-à-vis de l'oxygène, par exemple une couche en nitrure MN du métal M, ou en nitrure d'un autre métal (typiquement, en nitrure de titane TiN, en tungstène W ou en nitrure de Tantale TaN).

Ici, les différentes couches de la cellule mémoire 50 ; 60 ; 80 sont parallèles les unes aux autres (et parallèles au substrat en question). Elles forment ensemble un empilement qui s'étend selon un axe z perpendiculaire au plan des couches. Les différentes couches de la cellule mémoire 50 ; 60 ; 80 occupent ainsi des positions (des « cotes ») différentes le long de l'axe z.

De manière remarquable, la couche réservoir 55 ; 65 ; 85 mentionnée plus haut comprend une partie supérieure 551 ; 651 ; 851 formée par le métal M, et une partie inférieure 552 ; 652 ; 852 formée par un deuxième oxyde MOy. Le deuxième oxyde MOy est un oxyde dudit métal M et comporte une proportion y en oxygène telle que ce deuxième oxyde est électriquement conducteur.

Comme expliqué dans la partie intitulée « résumé de l'invention », le deuxième oxyde MOy est à la fois conducteur électriquement, et plus résistant à la gravure que le métal M qui forme la partie supérieure de la couche réservoir 55 ; 65 ; 85.

Une fois que la cellule mémoire 50 ; 60 ; 80 a été délimitée latéralement par gravure, la partie inférieure 552 ; 652 ; 852 de la couche réservoir 55 ; 65 ; 85 (formée du deuxième oxyde MOy) a donc une section plus grande que la partie supérieure 551 ; 651 ; 851 de la couche réservoir (formée du métal M), du fait de sa meilleure résistance à la gravure latérale (voir les figures 5, 6 et 8).

Cette partie inférieure 552 ; 652 ; 852 de la couche réservoir 55 ; 65 ; 85, formée du deuxième oxyde MOy, permet ainsi :
- de conserver à la couche réservoir sa fonction de zone de stockage d'oxygène (notamment grâce à sa partie supérieure formée du métal M),
- tout en bénéficiant, au-dessus de la couche active 54 ; 64 ; 84, d'une zone électriquement conductrice de section plus grande que la partie supérieure en métal M (grâce au caractère à la fois conducteur et résistant à la gravure du deuxième oxyde MOy).

Comme expliqué dans la partie « résumé de l'invention », le caractère étendu de cette zone conductrice 552 ; 652 ; 852 permet avantageusement de réduire la valeur de la tension de forming U_{F} à appliquer à la cellule mémoire pour créer le filament électriquement conducteur qui traverse la couche active 54 ; 64 ; 84. La tension de forming U_{F} de cette cellule mémoire 50 ; 60 ; 80 est notamment plus faible que celle d'une cellule mémoire qui aurait une face supérieure de même section, mais dans laquelle la couche réservoir serait formée seulement de métal (moins résistant à la gravure que l'oxyde MOy).

Réaliser cette zone 552 ; 652 ; 852, à la fois conductrice et résistance à la gravure, à partir d'un oxyde métallique qui est un oxyde du même métal que le métal M formant la partie supérieure 551 ; 651 ; 851 de la couche réservoir, permet une fabrication commode de la cellule mémoire.

En pratique, après gravure, lorsque la cellule mémoire 50 ; 60 ; 80 est de petite section (typiquement inférieure à 10⁻² micromètre carrés), la partie inférieure 552 ; 652 ; 852 de la couche réservoir 55 ; 65 ; 85 (en oxyde MOy) a une section dont l'aire A_{OX,5} ; A_{OX,6} ; A_{OX,8} est au moins 20 % plus grande que l'aire A_{M} de la section de la partie supérieure 551 ; 651 ; 851 de la couche réservoir, en métal M. Et même, lorsque la cellule mémoire 50 ; 60 ; 80 a un diamètre d'une quarantaine de nanomètres (diamètre de sa couche supérieure 6), l'aire A_{OX,5} ; A_{OX,6} ; A_{OX,8} de la partie inférieure en oxyde MOy peut être deux fois plus grande (et même plus) que l'aire A_{M} de sa partie supérieure (en métal M). Les sections mentionnées ci-dessus sont des sections droites de la cellule mémoire, selon des plans de coupe parallèles à l'électrode inférieure 2, et donc perpendiculaires à l'axe z introduit précédemment. Il s'agit en quelque sorte de sections « complètes » de la cellule mémoire (au niveau du plan de coupe considéré), délimitées par la surface latérale externe de la cellule mémoire.

On notera que le deuxième oxyde MOy, qui forme la partie inférieure de la couche réservoir 55 ; 65 ; 85, est bien distinct du premier oxyde EOx de la couche active 54 ; 64 ; 84.

En effet, la conductivité électrique σ2 du deuxième oxyde MOy (qui est électriquement conducteur) est ici supérieure, et même très supérieure à celle, σ1, du premier oxyde EOx (qui est électriquement isolant, sauf au niveau du filament conducteur mentionné plus haut). La conductivité électrique σ2 deuxième oxyde MOy, est par exemple supérieure ou égale à 100 Siemens par mètre. Et, en pratique, elle est généralement au moins mille fois, voire même plus d'un million de fois supérieure à celle, σ1, du premier oxyde EOx. En outre, le métal M de la couche réservoir, qui permet de stocker de l'oxygène provenant de la couche en premier oxyde EOx, est ici différent de l'élément E présent, sous forme oxydée (EOx), dans la couche active 54 ; 64 ; 84. A titre d'exemple, le métal M peut être du Titane Ti tandis que la couche active est alors réalisée en oxyde de silicium SiOx.

On notera d'ailleurs que la partie de la couche réservoir formée du deuxième oxyde MOy a une composition qui est également bien différente de celle de la partie supérieure de la couche réservoir, formée du métal M.

En effet, même si cette partie supérieure 551 ; 651 ; 851 comprend éventuellement une petite quantité d'oxygène, l'écart relatif entre, d'une part, la quantité y d'oxygène présent dans le deuxième oxyde MOy, et, d'autre part, la quantité ε d'oxygène éventuellement présent dans ladite partie supérieure, est ici supérieur à 50%, voire supérieur à 70%. Autrement formulé, la quantité (y-ε)/(y+ε) est ici supérieure à 0,5, voire supérieure à 0,7, y étant le nombre d'atomes d'oxygène par atome de métal M dans le deuxième oxyde MOy, et ε étant le nombre d'atomes d'oxygène par atome de métal M dans la partie supérieure en métal M (c'est-à-dire, plus précisément, dans la partie supérieurement de la couche réservoir, principalement formée dudit métal M, non oxydé, ou faiblement oxydé seulement).

A titre d'exemple, lorsque le métal M est du Titane, la proportion y d'oxygène dans le deuxième oxyde MOy peut être comprise entre 1 et 1,7, ce qui permet d'obtenir une conductivité électrique σ2 supérieure à 100 Siemens par mètre, la quantité ε d'oxygène éventuellement présent dans ladite partie supérieure en métal étant quant à elle inférieure à 0,5, voire même inférieure à 0,2.

Le deuxième oxyde est repéré par la référence MOy, sur les figures. Mais sa formule chimique brute peut aussi bien être MO_{y} (cas de l'oxyde de Titane TiOy, de l'oxyde d'Hafnium HfOy, ou de l'oxyde de Zirconium ZrOy, par exemple), que M₂O_{z} (avec z=2y), par exemple (cas de l'oxyde d'aluminium Al₂O_{z<3}, par exemple).

Au moins deux techniques différentes sont envisageables pour réaliser la couche réservoir 55 ; 65 ; 85 particulière mentionnée ci-dessus. Une première technique est basée sur un recuit spécifique, réalisé avant la gravure de la cellule mémoire. Une deuxième technique est basée sur des dépôts successifs de plusieurs sous-couches distinctes comprenant des proportions en oxygène différentes les unes des autres (par exemple une première sous-couche, puis une deuxième sous-couche).

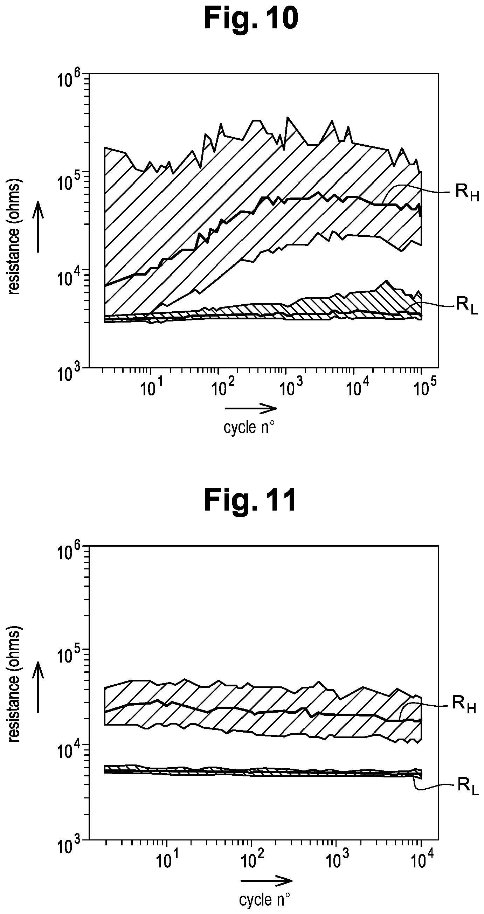

Un premier procédé de fabrication correspondant à la première technique (par recuit), ainsi que des exemples de cellules mémoires obtenues de cette manière sont présentés ci-dessous, dans un premier temps (figures 2 à 6). Un deuxième procédé de fabrication correspondant à la deuxième technique (par dépôts successifs) est présenté ensuite, en référence aux figures 7 et 8. Enfin, des résultats de mesure montrant la baisse de tension de forming obtenue sont présentés, en référence à la figure 9, ainsi que des résultats de tests d'endurance (figures 10 et 11).

Tel que représenté sur la figure 2, le premier procédé de fabrication comprend les étapes suivantes :
- étape St1 : déposer l'électrode inférieure 2, puis
- étape St2 : déposer la couche active sur l'électrode inférieure 2, puis
- étape St3 : produire l'électrode supérieure 53 ; 63 qui recouvre la couche active, puis
- étape St4 : former un filament électriquement conducteur dans la couche active, par claquage électrique contrôlé de la coucha active (étape de forming).

L'étape St3, de production de l'électrode supérieure 53 ; 63 est réalisée plus précisément en exécutant les étapes suivantes :
- étape St31 : produire la couche réservoir 55 ; 65 (destinée apte à accueillir de l'oxygène provenant la coucha active) grâce à la technique de recuit mentionnée plus haut ;
- étape St32 : déposer la couche de protection 6 qui recouvre la couche réservoir 55 ; 65, et
- étape St33 : graver l'électrode supérieure 53 ; 63, ainsi d'ailleurs que la couche active54 ; 64, de manière à délimiter latéralement la cellule mémoire 50 ; 60.

A l'étape St31, pour produire la couche réservoir 55 ; 65, il est prévu d'exécuter les sous-étapes suivantes :
- St310 : déposer une couche 35 dudit métal M sur la couche active, puis
- St311 : réaliser le recuit mentionné plus haut.

Comme on peut le voir sur la figure 2, l'opération de recuit, St311, est réalisée ici après le dépôt de la couche 35 en métal M, et même après le dépôt de la couche supérieure 6 de protection, en Nitrure MN. En variante, l'opération de recuit pourrait toutefois être réalisée après le dépôt de la couche 35 en métal M, mais avant le dépôt de la couche supérieure de protection (dans le cadre de cette variante, les étapes St310, St311 et St32 seraient alors exécutées dans l'ordre suivant : St310, puis St311 puis St32). Dans le cadre de cette variante, le recuit doit néanmoins être réalisé sans remise à l'air de la mémoire, et cela jusqu'au dépôt de la couche supérieure de protection (le recuit étant alors réalisé sous une atmosphère dépourvue d'oxygène, ou sous vide).

Ici, la couche 35 en métal M est déposée directement sur la couche active, contre celle-ci (sans couche intermédiaire). La figure 3 représente schématiquement l'empilement réalisé, avant recuit, et avant gravure (c'est-à-dire juste après la sous-étape St32).

Lors du recuit, la température (ou les températures) élevée appliquée à la cellule mémoire permet une diffusion d'oxygène depuis la couche active vers la couche 35 en métal M (initialement pauvre en oxygène).

Après recuit, au lieu de la couche 35 en métal M déposée initialement, on obtient alors une couche 45 comprenant, en partie inférieure, de l'oxyde MOy, et en partie supérieure, du métal M. La figure 4 représente schématiquement l'empilement de couches de la cellule mémoire, après recuit, et avant gravure (pour une durée de recuit relativement courte, pour laquelle la partie de la couche 45, située le plus bas dans cette couche, reste électriquement conductrice).

La couche réservoir 55 ; 65, obtenue par cette technique de recuit, présente une proportion en oxygène qui augmente progressivement, du bas vers le haut de la couche (c.f.: figures 5 et 6). Au sein de la couche réservoir, la concentration en oxygène augmente ainsi progressivement, continûment, avec la cote z du point considéré (la concentration en oxygène peut par exemple présenter un gradient non nul sur l'ensemble de l'épaisseur de la couche réservoir).

La durée, et la ou les températures de recuit sont choisies ici de manière à ne pas oxyder la partie supérieure de la couche 35, ou tout au moins, de manière à ne l'oxyder que très peu (pour cela, on limite la durée de recuit à une valeur pas trop grande). Ainsi, après recuit, dans la partie de la couche 45 située tout en haut de celle-ci, la proportion d'oxygène est de préférence inférieure à 0,5, voire même inférieure à 0,2 atome d'oxygène par atome de métal M.

La durée et la ou les températures de recuit sont choisies par ailleurs de manière à ce que, dans la partie inférieure de la couche 45, formée du deuxième oxyde MOy, la proportion y d'oxygène soit au moins supérieure à 1 (dans cette partie inférieure, le métal M est au moins partiellement oxydé - pour augmenter la résistance à la gravure de cette partie), tout en restant suffisamment faible pour que le deuxième oxyde MOy soit électriquement conducteur.

A titre d'exemple, pour une couche réservoir d'épaisseur comprise entre 1 et 15 nanomètres, une température de recuit comprise entre 220 et 280 degrés Celsius, de préférence de 260 degrés Celsius, et une durée de recuit de 1 à 10 minutes, de préférence de 3 minutes, permettent d'obtenir la structure souhaitée pour la couche réservoir, avec une partie supérieure en métal M, et une partie inférieure formée du deuxième oxyde MOy.

Après la sous-étape de recuit St311, la cellule mémoire est gravée, pour délimiter latéralement l'électrode supérieure 53 ; 63 et la couche active 54 ; 64. Cette gravure est une gravure par plasma halogéné. Ici, il s'agit plus précisément d'une gravure par plasma de dichlore Cl2 et de bromure d'hydrogène HBr.

Ce type de gravure est suffisamment efficace pour graver la couche supérieure de l'électrode, en Nitrure MN. Comme l'enthalpie de formation d'une liaison métal-métal M-M est inférieure à celle correspondant à une liaison métal-oxygène M-O, la partie de la couche réservoir 55 ; 65 formée du deuxième oxyde MOy est donc moins gravée latéralement que sa partie supérieure en métal M (c.f. : figures 5 et 6).

D'ailleurs, pour la plupart des métaux de la liste dans laquelle peut être choisi le métal M (liste qui comprend les éléments suivant : Ti, La, Al, Zr, Hf, Ta, Gd comme déjà indiqué), les enthalpies de formation correspondant aux liaisons métal-métal M-M, métal-azote M-N, métal-Chlore M-Cl et métal-oxygène M-O suivent l'ordre suivant : M-M<M-N<M-Cl<M-O, ce qui explique la bonne résistance à la gravure de la partie inférieure 552 ; 652 de la couche réservoir 55 ; 65 formée du deuxième oxyde MOy.

En pratique, au cours de l'étape de gravure, plusieurs cellules mémoires sont gravées en même temps. Lors de cette gravure, on peut prévoir de ne pas graver l'électrode inférieure 2 pour qu'elle reste commune aux différentes cellules mémoires de la mémoire. L'électrode inférieure pourrait toutefois être gravée elle aussi, soit lors de cette même étape de gravure, soit au cours d'une étape précédente de structuration de l'électrode inférieure 2 (non représentée sur la figure 2), réalisée par exemple entre le dépôt de l'électrode inférieure 2 (étape St1) et le dépôt de la couche active (étape St2.

Après l'étape de gravure St33, une électronique de pilotage des différentes cellules mémoires est généralement fabriquée (cette étape n'est pas représentée, sur les figures). Cette électronique permet notamment de réaliser l'opération de forming St4.

Lors de l'étape de forming St4, le filament électriquement conducteur mentionné plus haut est formé, pour la première fois, dans la couche active 54 ; 64. Pour cela, une tension électrique est appliquée entre l'électrode inférieure 2 et la couche supérieure 6 de la cellule mémoire. La valeur de cette tension est augmentée progressivement, jusqu'à devenir supérieure à la tension de forming U_{F} pour laquelle le filament conducteur se forme dans la couche active. En variante, l'étape de « forming » pourrait être réalisée en injectant un courant électrique contrôlé dans l'une des électrodes de la cellule mémoire, la valeur de ce courant étant augmentée progressivement jusqu'à ce que le filament conducteur se forme. Plus généralement, l'étape de « forming » peut être réalisée en pilotant la tension et/ou le courant appliqués à la cellule mémoire, selon un cycle de pilotage prédéterminé. Mais quel que soit le mode de pilotage choisi (en courant, en tension, ou mixte), lors de cette étape, la tension électrique entre l'électrode inférieure 2 et la couche supérieure 6 de la cellule mémoire est rendue supérieure à la tension de forming U_{F}.

La figure 5 montre un premier exemple de cellule mémoire 50 obtenue par ce premier procédé, après gravure.

Pour ce premier exemple, le recuit est relativement court, si bien que la partie de la couche réservoir 55 située le plus bas dans cette couche reste assez peu oxydée, et donc électriquement conductrice. La partie de la couche réservoir désignée précédemment comme la « partie inférieure 552 de la couche réservoir », formée du deuxième oxyde conducteur MOy, correspond alors à cette partie de la couche réservoir 55 située tout en bas de la couche réservoir. La partie inférieure 552 de la couche réservoir occupe ainsi une zone qui s'étend directement contre la face supérieure de la couche active 54, sur une épaisseur représentant une fraction de l'épaisseur totale de la couche réservoir. Cette zone s'étend par ailleurs sur toute la section de la couche réservoir, c'est-à-dire jusqu'à sa surface latérale externe. Même si elle n'est pas séparée du reste de la couche réservoir par une frontière abrupte, la partie inférieure 552, en oxyde conducteur MOy, forme donc une sorte de strate, parallèle à l'électrode inférieure 2.

La partie supérieure 551 de la couche réservoir occupe quant à elle une zone située tout en haut de la couche réservoir 55, et qui s'étend sur une épaisseur représentant une fraction de l'épaisseur totale de la couche réservoir. Cette zone s'étend, là aussi, sur toute une section de la cellule mémoire (jusqu'à la surface latérale externe de la cellule mémoire), en formant une sorte de strate parallèle à l'électrode inférieure 2.

Le recuit qui, dans la couche réservoir, permet d'obtenir la partie inférieure 552 en oxyde conducteur MOy, a aussi pour effet de légèrement modifier de la couche active 54. Du fait du recuit, une différence de concentration en oxygène apparait entre le bas et le haut de la couche active 54. Dans sa partie supérieure, la couche active 54 comprend ainsi une proportion en oxygène x' plus faible que la proportion en oxygène x dans sa partie inférieure. La partie inférieure de la couche active 54, formée du premier oxyde EOx, reste néanmoins complètement isolante électriquement (sauf au niveau du filament électriquement conducteur mentionné plus haut).

Après gravure, la couche supérieure 6 de la cellule mémoire 50 (en nitrure MN) a une section d'aire A_{T} (il s'agit d'ailleurs de l'aire de la face supérieure de cette couche). La partie supérieure 551 de la couche réservoir 55, moins résistance à la gravure, a une section d'aire A_{M} notablement plus petite que l'aire A_{T} de la couche supérieure (effet d'« undercut » marqué). La partie inférieure 552 de la couche réservoir, plus résistance à la gravure latérale, a quant à elle une section d'aire A_{ox,5} nettement plus grande que celle, A_{M}, de la partie supérieure 551 de la couche réservoir, en métal M. L'aire A_{ox,5} de la section de la partie inférieure 552 est d'ailleurs proche de l'aire de la section de la couche active 54 (voire même égale à l'aire de la section de la couche active 54). Comme expliqué en détail plus haut, cela permet de réduire nettement la valeur de la tension de forming U_{F}, par rapport au cas d'une couche réservoir qui serait formée entièrement du métal M.

Quant à l'électrode inférieure 2, qu'elle ait été gravée ou non, sa section est plus étendue que celle de la couche active 54, et que la section de la couche supérieure 6. Ce sont donc les dimensions latérales de l'électrode supérieure et de la couche active qui définissent l'extension latérale de la partie « active » de la cellule mémoire.

La figure 6 montre un deuxième exemple de cellule mémoire 60, obtenue par le premier procédé décrit ci-dessus, après gravure. La durée du recuit est plus importante pour ce deuxième exemple, que pour le premier exemple de la figure 5.

Du fait de cette durée de recuit plus importante, la partie de la couche réservoir 65 qui est située le plus bas dans cette couche, contre la couche active 64, est alors électriquement isolante.

Mais comme la concentration en oxygène décroit progressivement du bas vers le haut de la couche réservoir 65, à partir d'une certaine hauteur, le matériau qui forme la couche réservoir devient conducteur. En d'autres termes, à partir de cette hauteur, la concentration en oxygène est suffisamment faible pour que ce matériau corresponde au deuxième oxyde MOy, électriquement conducteur.

Pour ce deuxième exemple, la couche réservoir 65 comprend donc :
- tout en bas, une partie isolante, formée d'un troisième oxyde MOy', qui est un oxyde du métal M avec une proportion en oxygène y' telle que le troisième oxyde est électriquement isolant,
- tout en haut, ladite partie supérieure 651, formée du métal M, et
- entre la partie isolante et la partie supérieure 651, ladite partie inférieure 652, formée du deuxième oxyde MOy, électriquement conducteur.

Lorsque le métal M est du Titane, le troisième oxyde peut avoir pour formule chimique TiO₂, ou, plus généralement TiO_{y'>1,7}.

Sur la figure 6, la transition entre la partie isolante et la partie conductrice de la couche réservoir 65 est représentée schématiquement par une ligne, qui porte la référence T. Cette transition peut correspondre par exemple au passage d'une conductivité électrique inférieure à 100 Siemens par mètre, à une conductivité électrique supérieure à 100 Siemens par mètre.

On voit sur cet exemple que la partie de la couche réservoir 65 désignée comme « la partie inférieure de la couche réservoir » est certes située en dessous de la partie supérieure en métal, mais pas nécessairement tout en bas de la couche réservoir. Ici, la partie inférieure 652 de la couche réservoir (en oxyde conducteur MOy) occupe plus précisément la zone située juste au-dessus de la transition T entre la partie isolante et la partie conductrice.

Quoiqu'il en soit, la partie inférieure 652 de la couche réservoir, formée du deuxième oxyde MOy occupe une zone qui s'étend sur toute la section de la couche réservoir (c'est-à-dire jusqu'à sa surface latérale externe) et sur une épaisseur représentant une fraction de l'épaisseur totale de la couche réservoir, comme pour la cellule mémoire 50 de la figure 5.

Après gravure, la couche supérieure 6 de la cellule mémoire 60 (en nitrure MN) a, là encore, une section d'aire A_{T}. La partie supérieure 651 de la couche réservoir, moins résistance à la gravure, a une section d'aire A_{M} notablement plus petite que l'aire A_{T} de la couche supérieure (« undercut » marqué). Et la partie inférieure 652 de la couche réservoir, plus résistance à la gravure latérale, a là aussi une section d'aire A_{ox,6} nettement plus grande que l'aire A_{M} de la section de la partie supérieure 651 en métal M.

Ainsi, malgré la formation d'une partie isolante tout en bas de la couche réservoir 65, on obtient quand même, au-dessus de la couche active 64, une zone électriquement conductrice, d'aire A_{ox,6} plus grande que la partie en métal 651, ce qui permet de réduire la valeur de la tension de forming U_{F} (car le potentiel électrique correspondant est appliqué, au-dessus de la couche active, sur une aire plus grande qu'avec une couche réservoir entièrement en métal M).

Pour ce qui est de l'électrode inférieure 2, de même que pour la cellule mémoire de la figure 5, sa section est plus étendue que celle de la couche active 54, et que celle de la couche supérieure 6.

La comparaison des premier et deuxième exemples de cellules mémoire 50, 60 montre que la durée du recuit, plus ou moins longue, peut être choisie avec une certaine liberté, du moment que le haut de la couche réservoir (essentiellement en métal M) reste peu oxydé tandis que le bas de cette couche est au moins partiellement oxydé (avec au moins un atome d'oxygène par atome de métal M, par exemple).

Une durée et une température de recuit, qui permettent d'obtenir la couche réservoir 55 ou 65 décrite ci-dessus, peuvent être déterminées en réalisant des essais, pour plusieurs durées différentes, par exemple, jusqu'à obtenir réduction souhaitée de la tension de forming (voir la figure 9). Au cours de ces essais, la structure de la couche réservoir peut éventuellement être sondée (par exemple en réalisant des coupes de type « EdX », c'est-à-dire par une méthode de caractérisation de type « Energy Dispersive X-ray ») pour tester sa composition chimique.

Il est noté à nouveau que la sous-étape St311 de recuit est réalisé avant l'étape de gravure de la cellule mémoire St 33, pour que la partie inférieure 552 ; 652 de la couche réservoir ait acquis une bonne résistance à la gravure avant de graver la cellule.

Ce premier procédé de fabrication peut comprendre des étapes supplémentaires, en plus des étapes décrites ci-dessus, par exemple des étapes de dépôt de couches additionnelles (non représentées sur les figures 5 et 6).

Le deuxième procédé de fabrication d'une cellule mémoire 80 conforme à l'invention est représenté schématiquement sur la figure 7. Comme déjà indiqué, au cours de ce deuxième procédé, la couche réservoir 85 est réalisée par dépôts successifs de différentes sous-couches, distinctes les unes des autres et comprenant des proportions différentes en oxygène.

Le deuxième procédé comprend les étapes suivantes :
- étape St1 : déposer l'électrode inférieure 2, puis
- étape St2 : déposer la couche active 84 sur l'électrode inférieure 2, couche active qui ici est formée entièrement du premier oxyde EOx décrit plus haut, puis
- étape St3' : produire l'électrode supérieure 83 qui recouvre la couche active 84, puis
- étape St4 : former un filament électriquement conducteur dans la couche active 84, par claquage électrique contrôlé de la coucha active (étape de forming).

Les étapes St1, St2 et St4 sont ici identiques, ou tout au moins essentiellement identiques aux étapes St1, St2 et St4 du premier procédé.

Et l'étape St3', de production de l'électrode supérieure 83, comprend là aussi les étapes suivantes :
- étape St31' : produire la couche réservoir 85, destinée apte à accueillir de l'oxygène provenant la coucha active ;
- étape St32 : déposer la couche de protection 6 qui recouvre la couche réservoir 55 ; 85, et
- étape St33 : graver l'électrode supérieure 83, ainsi d'ailleurs que la couche active 84, de manière à délimiter latéralement la cellule mémoire 80.

Mais l'étape St31' de production de la couche réservoir 85, basée sur des dépôts successifs de différentes sous-couches (plutôt que sur un recuit avec diffusion d'oxygène), est bien différente de l'étape St31 du premier procédé.

Ici, l'étape St31' comprend plus précisément les sous-étapes suivantes :
- St310' : dépôt d'une première sous-couche formant la partie inférieure 852 de la couche réservoir 85, puis
- St311' dépôt d'une deuxième sous-couche, qui recouvre la première sous-couche 852 et qui forme la partie supérieure 851 de la couche réservoir 85.

La première sous-couche 852 est formée du deuxième oxyde MOy. Elle est déposée par exemple par pulvérisation cathodique. Cette pulvérisation cathodique peut être réalisée à partir d'une cible qui est elle-même formée du deuxième oxyde MOy. La pulvérisation cathodique peut aussi être réalisée à partir d'une cible formée du métal M, mais sous une atmosphère comprenant de l'oxygène. Dans ce dernier cas, la pression partielle en oxygène dans l'atmosphère en question, dans l'enceinte où est réalisé le dépôt, est telle que la première sous-couche 852 déposée soit effectivement formée par le deuxième oxyde MOy, avec la proportion en oxygène y souhaitée (c'est-à-dire telle que le deuxième oxyde MOy soit électriquement conducteur).

Là encore, après gravure, la partie inférieure 852 de la couche réservoir 85 a une section d'aire A_{ox,8} plus grande que l'aire A_{M} d'une section de la partie supérieure 851 formée du métal M (voir la figure 8).

Ce deuxième procédé de fabrication peut lui aussi comprendre des étapes supplémentaires, en plus des étapes décrites ci-dessus, par exemple des étapes de dépôt de couches additionnelles (non représentées sur la figure 8), ou une étape de structuration de l'électrode inférieure 2, réalisée par exemple entre le dépôt de l'électrode inférieure 2 (étape St1) et le dépôt de la couche active (étape St2).

La figure 9 montre des valeurs de la tension de forming U_{F} obtenues :
- pour des cellules mémoires dont la couche réservoir est formée seulement du métal M (valeurs U₄₀, U₈₀ et U₁₂₀), comme c'est le cas pour la cellule mémoire 1 de l'art antérieur représentée sur la figure 1, et
- pour des cellules mémoires conforme à l'invention, pour lesquelles la partie inférieure de la couche réservoir est formée du deuxième oxyde conducteur MOy (valeurs U'₄₀, U'₈₀ et U'₁₂₀).

En l'occurrence, les différentes valeurs de la tension de forming U_{F} représentées sur la figure 9 correspondent à des cellules mémoire dans lesquelles le métal M est du titane Ti, et dans lesquelles le premier oxyde EOx de la couche active est de l'oxyde de silicium SiO₂. Ces valeurs correspondent à différentes tailles de cellules mémoire, la face supérieure de la cellule ayant un diamètre qui vaut respectivement 40, 80 et 120 nanomètres environ.

Les valeurs U'₄₀, U'₈₀ et U'₁₂₀ sont des valeurs de la tension de forming U_{F} obtenues pour des cellules mémoires conformes à l'invention (telles que celle de la figure 5, ou de la figure 6), réalisées par recuit au moyen du premier procédé de fabrication décrit plus haut. On rappelle que le recuit en question est réalisé avant la gravure de la cellule, mais après le dépôt de la couche 35 en métal M, couche qui est destinée à devenir la couche réservoir 55 ; 65 (le recuit est réalisé après le dépôt de la couche 35, afin de permettre la formation d'une oxyde conducteur MOy, dans cette couche). Les valeurs U'₄₀, U'₈₀ et U'₁₂₀ correspondent à des diamètres de la face supérieure de la cellule de 40, 80 et 120 nanomètres respectivement.

Quant aux valeurs U"₄₀, U"₈₀ et U"₁₂₀, il s'agit de valeurs de la tension de forming U_{F} obtenues pour des cellules mémoires réalisées comme dans le cas de la figure 1, mais avec un recuit, ce recuit étant effectué avant le dépôt de la couche réservoir 5 en métal M. Les valeurs U"₄₀, U"₈₀ et U"₁₂₀ correspondent là aussi à des diamètres de la face supérieure de la cellule de 40, 80 et 120 nanomètres respectivement.

Mis à part les différences indiquées ci-dessus (qui concernent la réalisation ou non d'un recuit), les différentes cellules mémoires, dont les valeurs de tension de forming sont données figure 9, sont fabriquées de la même manière.

L'exemple de la figure 9 illustre que les valeurs U'₄₀, U'₈₀ et U'₁₂₀ de la tension de forming U_{F}, obtenues avec une couche réservoir dont la partie inférieure est formée du deuxième oxyde conducteur MOy, sont nettement inférieures à celles, U₄₀, U₈₀ et U₁₂₀ obtenues avec une couche réservoir classique formée seulement du métal M.

A titre d'exemple, pour une cellule mémoire ayant une face supérieure de 40 nanomètres de diamètre environ :
- la valeur U₄₀ de la tension de forming, avec une couche réservoir formée seulement du métal M (cellule mémoire de la figure 1), est de 4,8 volts environ,
- alors que la valeur U'₄₀ de la tension de forming, obtenue pour une cellule mémoire réalisée conformément au premier procédé (cellule mémoire de la figure 5, ou 6), est de 2 volts seulement.

On notera que la baisse de tension de forming constatée ne saurait s'expliquer seulement par une modification de la couche active 54 ; 64 due au recuit. En effet, lorsque le recuit est réalisé *avant* le dépôt de la couche 35 en métal M ( et donc lorsqu'il n'affecte que la couche active, et non la couche réservoir), on obtient des valeurs U"₄₀, U"₈₀ et U"₁₂₀ de tension de forming qui sont certes plus faibles qu'en l'absence de recuit, mais qui restent néanmoins supérieures à ce que l'on obtient lorsque le recuit est effectué *après* le dépôt de la couche 35 en métal M.

Pour la cellule mémoire dont la face supérieure a un diamètre de 40 nanomètres environ, par exemple, la valeur U"₄₀ de la tension de forming, lorsque le recuit est réalisé avant le dépôt de la couche 35 en métal, est de 3,7 volts environ, alors que l'on obtient une valeur U'₄₀ de 2 volts seulement lorsque le recuit est réalisé après le dépôt de la couche 35 en métal M (couche qui forme finalement la couche réservoir).

Les figures 10 et 11 montrent des résultats d'un test d'endurance réalisé respectivement pour une cellule mémoire de l'art antérieur, telle que celle de la figure 1 (figure 10), et pour une cellule mémoire réalisée conformément au procédé de la figure 2 (telle que la cellule mémoire 50 de la figure 50, ou celle, 60, de la figure 6).

Sur chacune de ces figures, on a représenté les valeurs d'une résistance basse R_{L}, et d'une résistance haute R_{H} de la cellule mémoire considérée, au cours de dix mille cycles successifs d'écriture et de remise à zéro de la cellule mémoire.

La résistance haute R_{H} de la cellule mémoire est sa résistance électrique, mesurée entre l'électrode inférieure 2 et la couche supérieure 6 de l'électrode supérieure, lorsque le filament conducteur qui traverse la couche active est rompu (c'est-à-dire après une étape de remise à zéro - étape de RESET - de la cellule mémoire).

La résistance basse R_{L} de la cellule mémoire est sa résistance électrique, mesurée entre l'électrode inférieure et la couche supérieure de l'électrode supérieure, lorsque le filament conducteur a été reformé (c'est-à-dire après une étape d'écriture - étape de SET - de la cellule mémoire).

Pour la cellule mémoire de la figure 1, les valeurs de la résistance basse R_{L} restent stables, autour de 3 kiloohms, au cours des cycles successifs d'écriture et de remise à zéro (voir la figure 10). Quant aux valeurs de la résistance haute R_{H}, elles augmentent progressivement au cours des cycles d'écriture et de remise à zéro, en partant de 6 kiloohms environ pour se stabiliser, après mille cycles environ, autour de 40 kiloohms.

Pour la cellule mémoire de la figure 5 (ou 6), les valeurs de la résistance basse R_{L} restent également stables, autour de 5 kiloohms, au cours des cycles successifs d'écriture et de remise à zéro (voir la figure 11). Les valeurs de la résistance haute R_{H}, égales à 20 kiloohms environ, restent elles aussi stables au cours des cycles successifs d'écriture et de remise à zéro. On obtient donc un rapport R_{H}/R_{L}, entre la résistance haute et la résistance basse, assez élevé, de 4 environ, et qui reste très stable au cours de ces nombreux cycles d'écriture et de remise à zéro. L'écart substantiel, et stable obtenu ainsi entre la résistance haute R_{H} et la résistance basse R_{L} facilite la lecture de la cellule mémoire proposée ici, et rend cette lecture plus fiable.

## Revendications

1. Cellule mémoire (50 ; 60 ; 80) résistive de type OxRAM comprenant une électrode inférieure (2), une électrode supérieure (53 ; 63 ; 83), et une couche active (54 ; 64 ; 84) qui s'étend entre l'électrode inférieure (2) et l'électrode supérieure (53 ; 63 ; 83),
- la couche active (54 ; 64 ; 84) comprenant au moins une couche d'un premier oxyde (EOx) électriquement isolant, dans lequel un filament électriquement conducteur peut être formé, puis ultérieurement rompu et formé à nouveau plusieurs fois successivement,
- l'électrode supérieure (53 ; 63 ; 83) comprenant une couche réservoir (55 ; 65 ; 85) apte à accueillir de l'oxygène, une partie au moins de la couche réservoir (55 ; 65 ; 85) étant formée d'un métal (M),
- **caractérisée en ce que** ladite couche réservoir (55 ; 65 ; 85) comprend une partie supérieure (551 ; 651 ; 851) formée par ledit métal (M) et une partie inférieure (552 ; 652 ; 852) formée par un deuxième oxyde (MOy), le deuxième oxyde (MOy) étant un oxyde dudit métal (M) et comportant une proportion (y) d'oxygène telle que le deuxième oxyde est électriquement conducteur, avec une conductivité électrique supérieure à 100 Siemens par mètre.

2. Cellule mémoire (50 ; 60) selon la revendication 1, dans laquelle la couche réservoir (55 ; 65) comprend une proportion d'oxygène qui varie progressivement depuis la partie inférieure (552 ; 652) de la couche réservoir jusqu'à sa partie supérieure (551 ; 651).

3. Cellule mémoire (80) selon la revendication 1, dans laquelle :
- la partie inférieure de la couche réservoir (85) est formée par une première sous-couche (852) formée dudit deuxième oxyde (MOy), et dans laquelle
- la partie supérieure de la couche réservoir (85) est formée par une deuxième sous-couche (851), distincte de la première sous-couche (852) et formée dudit métal (M).

4. Cellule mémoire (50 ; 60 ; 80) selon l'une quelconque des revendications précédentes, la cellule ayant été délimitée latéralement par gravure, dans laquelle la partie inférieure (552 ; 652 ; 852) de la couche réservoir (55 ; 65 ; 85), formée du deuxième oxyde, a une section (A_{OX,5} ; A_{OX,6} ; A_{OX,8}) plus grande que la section (A_{M}) de la partie supérieure (551 ; 651 ; 851) de la couche réservoir, formée dudit métal (M).

5. Cellule mémoire (50 ; 60 ; 80) selon l'une quelconque des revendications précédentes, dans laquelle ledit métal (M) est l'un des métaux suivants : Le Titane, le Lanthane, l'Aluminium, le Zirconium, l'Hafnium, le Gadolinium, le Tantale.

6. Cellule mémoire (50 ; 60 ; 80) selon l'une quelconque des revendications précédentes dans laquelle le premier oxyde (EOx) est un oxyde d'un élément chimique (E) différent dudit métal (M).

7. Cellule mémoire (50 ; 60 ; 80) selon l'une quelconque des revendications précédentes dans laquelle ledit métal (M) est du Titane et dans laquelle la proportion (y) d'oxygène dans le deuxième oxyde (MOy) est inférieure à 1,7 atomes d'oxygène par atome de Titane.

8. Cellule mémoire (50 ; 60 ; 80) selon l'une quelconque des revendications précédentes dans laquelle le premier oxyde (EOx) est un oxyde de Silicium.

9. Procédé de fabrication d'une cellule mémoire résistive (50 ; 60 ; 80) de type OxRAM, comprenant les étapes suivantes :
- (St1) déposer une électrode inférieure (2), puis
- (St2) déposer une couche active (54 ; 64 ; 84) sur l'électrode inférieure (2), la couche active comprenant au moins une couche formée d'un premier oxyde (EOx), le premier oxyde étant électriquement isolant et étant apte à servir de support à la formation d'un filament électriquement conducteur traversant ledit premier oxyde, le filament pouvant être rompu puis formé à nouveau plusieurs fois successivement, puis
- (St3 ; St3') produire une électrode supérieure (53 ; 63 ; 83) recouvrant la couche active, en exécutant les étapes suivantes :
o (St31 ; St31') produire une couche réservoir (55 ; 65 ; 85) apte à accueillir de l'oxygène, une partie au moins de la couche réservoir étant formée d'un métal (M), et
o (St33) graver l'électrode supérieure (53 ; 63 ; 83) de manière à délimiter latéralement la cellule mémoire, l'étape de gravure (St33) étant réalisée après l'étape de production de ladite couche réservoir (St31 ; St31'), l'étape (St31 ; St31') de production de la couche réservoir (55 ; 65 ; 85) étant réalisée de manière à ce que la couche réservoir comprenne une partie supérieure (551 ; 651 ; 851) formée par ledit métal (M), et une partie inférieure (552 ; 652 ; 852) formée par un deuxième oxyde (MOy), le deuxième oxyde (MOy) étant un oxyde dudit métal (M) comportant une proportion (y) d'oxygène telle que le deuxième oxyde (MOy) est électriquement conducteur, avec une conductivité électrique supérieure à 100 Siemens par mètre.

10. Procédé selon la revendication 9, dans lequel l'étape (St31) de production de la couche réservoir (55 ; 65) comprend les sous-étapes suivantes :
- (St310) déposer une couche (35) dudit métal (M) sur la couche active (54 ; 64), puis
- (St311) réaliser un recuit à une température et pendant une durée telles que la couche précédemment déposée comprenne, après recuit : ladite partie supérieure (551 ; 651) formée par ledit métal (M), ainsi que ladite partie inférieure (552 ; 652) formée par le deuxième oxyde (MOy) électriquement conducteur.

11. Procédé selon la revendication 9, dans lequel l'étape (St31') de production de la couche réservoir (85) comprend les sous-étapes suivantes :
- (St310') déposer une première sous-couche (852) sur la couche active (84), la première sous-couche (852) étant formée du deuxième oxyde (MOy), puis
- (St311') déposer une deuxième sous-couche (851) sur la première sous-couche (852), la deuxième sous-couche (851) étant formée dudit métal (M).

12. Procédé selon la revendication 11 dans lequel la sous-étape (310') de dépôt de la première sous-couche (852) est réalisée :
- par pulvérisation cathodique à partir d'une cible formée dudit deuxième oxyde (MOy) électriquement conducteur, ou par
- pulvérisation cathodique à partir d'une cible formée dudit métal (M), sous une atmosphère comprenant de l'oxygène, la pression partielle d'oxygène dans ladite atmosphère étant telle que la première sous-couche (852) déposée soit formée par ledit deuxième oxyde (MOy), avec ladite proportion (y) en oxygène.

13. Procédé selon l'une quelconque des revendications 9 à 12, dans lequel l'étape de gravure (St33) est une gravure par plasma halogéné.

## Patentansprüche

1. Resistive Speicherzelle (50; 60; 80) vom Typ OxRAM mit einer unteren Elektrode (2), einer oberen Elektrode (53; 63; 83) und einer aktiven Schicht (54; 64; 84), die sich zwischen der unteren Elektrode (2) und der oberen Elektrode (53; 63; 83) erstreckt,
- wobei die aktive Schicht (54; 64; 84) mindestens eine Schicht aus einem ersten elektrisch isolierenden Oxid (EOx) umfasst, in dem ein elektrisch leitender Glühdraht gebildet werden kann, der später unterbrochen und mehrere Male hintereinander wieder gebildet werden kann,
- wobei die obere Elektrode (53; 63; 83) eine Reservoirschicht (55; 65; 85) umfasst, die geeignet ist, Sauerstoff aufzunehmen, wobei zumindest ein Teil der Reservoirschicht (55; 65; 85) aus einem Metall (M) gebildet ist,
- **dadurch gekennzeichnet, dass** die Reservoirschicht (55; 65; 85) einen oberen Teil (551; 651; 851) umfasst, der durch dieses Metall (M) gebildet wird, und einen unteren Teil (552; 652; 852), der durch ein zweites Oxid (MOy) gebildet wird, wobei das zweite Oxid (MOy) ein Oxid des Metalls (M) ist und einen solchen Anteil (y) an Sauerstoff aufweist, dass das zweite Oxid elektrisch leitfähig ist, mit einer elektrischen Leitfähigkeit von mehr als 100 Siemens pro Meter.

2. Speicherzelle (50; 60) nach Anspruch 1, in der die Reservoirschicht (55; 65) einen Sauerstoffanteil umfasst, der sich allmählich vom unteren Teil (552; 652) der Reservoirschicht bis zu ihrem oberen Teil (551; 651) ändert.

3. Speicherzelle (80) nach Anspruch 1, in der:
- der untere Teil der Reservoirschicht (85) durch eine erste Unterschicht (852) gebildet wird, die aus dem zweiten Oxid (MOy) gebildet wird, und in der
- der obere Teil der Reservoirschicht (85) durch eine zweite Unterschicht (851) gebildet wird, die sich von der ersten Unterschicht (852) unterscheidet und aus dem Metall (M) gebildet wird.

4. Speicherzelle (50; 60; 80) nach einem der vorhergehenden Ansprüche, wobei die Zelle durch Ätzen seitlich begrenzt wird, in der der untere Teil (552; 652; 852) der Reservoirschicht (55; 65; 85), der aus dem zweiten Oxid gebildet wird, einen Querschnitt (Aox,s; A_{OX,6}; Aox,s) aufweist, der größer ist als der Querschnitt (A_{M}) des oberen Teils (551; 651; 851) der Reservoirschicht, der aus dem Metall (M) gebildet wird.

5. Speicherzelle (50; 60; 80) nach einem der vorhergehenden Ansprüche, in der das Metall (M) eines der folgenden Metalle ist: Titan, Lanthan, Aluminium, Zirkonium, Hafnium, Gadolinium, Tantal.

6. Speicherzelle (50; 60; 80) nach einem der vorhergehenden Ansprüche, in der das erste Oxid (EOx) ein Oxid eines chemischen Elements (E) ist, das sich von dem Metall (M) unterscheidet.

7. Speicherzelle (50; 60; 80) nach einem der vorhergehenden Ansprüche, in der das Metall (M) Titan ist und in der der Sauerstoffanteil (y) im zweiten Oxid (MOy) bei unter 1,7 Sauerstoffatome pro Titanatom beträgt.

8. Speicherzelle (50; 60; 80) nach einem der vorhergehenden Ansprüche, in der das erste Oxid (EOx) ein Siliziumoxid ist.

9. Verfahren zur Herstellung einer resistiven Speicherzelle (50; 60; 80) vom Typ OxRAM, das folgende Schritte umfasst:
- Auftragen (St1) einer unteren Elektrode (2), dann
- St2) Auftragen einer aktiven Schicht (54; 64; 84) auf die untere Elektrode (2), wobei die aktive Schicht mindestens eine aus einem ersten Oxid (EOx) gebildete Schicht umfasst, wobei das erste Oxid elektrisch isolierend ist und als Träger für die Bildung eines elektrisch leitenden Glühdrahts dienen kann, der durch das erste Oxid verläuft, wobei der Glühdraht unterbrochen und dann mehrere Male nacheinander neu gebildet werden kann, und dann
- (St3; St3') Herstellen einer oberen Elektrode (53; 63; 83), die die aktive Schicht bedeckt, durch Ausführen der folgenden Schritte:
o (St31; St31') Herstellen einer Reservoirschicht (55; 65; 85), die Sauerstoff aufnehmen kann, wobei zumindest ein Teil der Reservoirschicht aus einem Metall (M) gebildet ist, und
o (St33) Ätzen der oberen Elektrode (53; 63; 83), um die Speicherzelle seitlich zu begrenzen, wobei das Ätzen (St33) nach der Herstellung der Reservoirschicht (St31; St31') durchgeführt wird, wobei die Herstellung (St31; St31`) der Reservoirschicht (55; 65; 85) so durchgeführt wird, dass die Reservoirschicht einen oberen Teil (551 ; 651; 851), der durch das Metall (M) gebildet wird, und einen unteren Teil (552; 652; 852), der durch ein zweites Oxid (MOy) gebildet wird, umfasst, wobei das zweite Oxid (MOy) ein Oxid des Metalls (M) ist, das einen solchen Sauerstoffanteil (y) aufweist, dass das zweite Oxid (MOy) elektrisch leitfähig ist, mit einer elektrischen Leitfähigkeit von mehr als 100 Siemens pro Meter.

10. Verfahren nach Anspruch 9, bei dem der Schritt (St31) zur Herstellung der Reservoirschicht (55; 65) die folgenden Teilschritte umfasst:
- (St310) Auftragen einer Schicht (35) des Metalls (M) auf die aktive Schicht (54; 64), und dann
- (St311) Glühen bei einer entsprechenden Temperatur und während einer entsprechenden Dauer, dass die zuvor aufgetragene Schicht nach dem Glühen umfasst: den oberen Teil (551; 651), der durch das Metall (M) gebildet wird, sowie den unteren Teil (552; 652), der durch das zweite elektrisch leitende Oxid (MOy) gebildet wird.

11. Verfahren nach Anspruch 9, bei dem der Schritt (St31') zur Herstellung der Reservoirschicht (85) die folgenden Teilschritte umfasst:
- (St310') Auftragen einer ersten Unterschicht (852) auf die aktive Schicht (84), wobei die erste Unterschicht (852) aus dem zweiten Oxid (MOy) gebildet wird, und dann
- (St311`) Auftragen einer zweiten Unterschicht (851) auf die erste Unterschicht (852), wobei die zweite Unterschicht (851) aus dem Metall (M) gebildet wird.

12. Verfahren nach Anspruch 11, bei dem der Teilschritt (310') des Auftragens der ersten Unterschicht (852) durchgeführt wird:
- durch Sputtern aus einem Target, das aus dem elektrisch leitfähigen zweiten Oxid (MOy) gebildet ist, oder durch
- Sputtern aus einem Target, das aus dem Metall (M) gebildet ist, in einer Sauerstoff enthaltenden Atmosphäre, wobei der Sauerstoff-Partialdruck in der Atmosphäre so ist, dass die erste aufgetragene Unterschicht (852) durch das zweite Oxid (MOy) mit diesem Sauerstoffanteil (y) gebildet wird.

13. Verfahren nach einem der Ansprüche 9 bis 12, bei dem das Ätzen (St33) durch Ätzen mit Halogenplasma erfolgt.

## Claims

1. OxRAM resistive memory cell (50; 60; 80) comprising a lower electrode (2), an upper electrode (53; 63; 83), and an active layer (54; 64; 84) which extends between the lower electrode (2) and the upper electrode (53; 63; 83),
- the active layer (54; 64; 84) comprising at least one layer of a first electrically insulating oxide (EOx), wherein an electrically conductive filament can be formed, then subsequently broken and reformed several times successively,
- the upper electrode (53; 63; 83) comprising a reservoir layer (55; 65; 85) capable of receiving oxygen, a portion at least of the reservoir layer (55; 65; 85) being made of a metal (M),
- **characterised in that** said reservoir layer (55; 65; 85) comprises an upper part (551; 651; 851) made of said metal (M) and a lower part (552; 652; 852) made of a second oxide (MOy), the second oxide (MOy) being an oxide of said metal (M) and comprising a proportion (y) of oxygen such that the second oxide is electrically conductive, with an electrical conductivity greater than 100 Siemens per metre.

2. Memory cell (50; 60) according to claim 1, wherein the reservoir layer (55; 65) comprises a proportion of oxygen that varies progressively from the lower part (552; 652) of the reservoir layer to its upper part (551; 651).

3. Memory cell (80) according to claim 1, wherein:
- the lower part of the reservoir layer (85) is a first sub-layer (852) made of said second oxide (MOy), and wherein
- the upper part of the reservoir layer (85) is a second sub-layer (851), distinct from the first sub-layer (852) and made of said metal (M).

4. Memory cell (50; 60; 80) according to any preceding claim, the cell having been delimited laterally by etching, wherein the lower part (552; 652; 852) of the reservoir layer (55; 65; 85), made of the second oxide, has a section (A_{OX,5}; A_{OX,6}; A_{OX,8}) that is larger than the section (A_{M}) of the upper part (551; 651; 851) of the reservoir layer, made of said metal (M).

5. Memory cell (50; 60; 80) according to any preceding claim, wherein said metal (M) is one of the following metals: Titanium, Lanthanum, Aluminium, Zirconium, Hafnium, Gadolinium, Tantalum.

6. Memory cell (50; 60; 80) according to any preceding claim wherein the first oxide (EOx) is an oxide of a chemical element (E) different from said metal (M).

7. Memory cell (50; 60; 80) according to any preceding claim wherein said metal (M) is Titanium and wherein the proportion (y) of oxygen in the second oxide (MOy) is less than 1.7 Oxygen atoms per Titanium atom.

8. Memory cell (50; 60; 80) according to any preceding claim wherein the first oxide (EOx) is a Silicon oxide.

9. Method for manufacturing an OxRAM resistive memory cell (50; 60; 80), comprising the following steps:
- (St1) depositing a lower electrode (2), then
- (St2) depositing an active layer (54; 64; 84) on the lower electrode (2), the active layer comprising at least one layer made of a first oxide (EOx), the first oxide being electrically insulating and able to be used as a support for the formation of an electrically conductive filament passing through said first oxide, the filament being able to be broken then formed again several times successively, then
- (St3; St3') producing an upper electrode (53; 63; 83) covering the active layer, by executing the following steps:
o (St31; St31') producing a reservoir layer (55; 65; 85) capable of receiving oxygen, a portion at least of the reservoir layer being made of a metal (M), and
o (St33) etching the upper electrode (53; 63; 83) in such a way as to laterally delimit the memory cell, the step of etching (St33) being carried out after the step of producing said reservoir layer (St31; St31'),
the step (St31; St31') of producing the reservoir layer (55; 65; 85) being carried out in such a way that the reservoir layer includes an upper part (551; 651; 851) made of said metal (M), and a lower part (552; 652; 852) made of a second oxide (MOy), the second oxide (MOy) being an oxide of said metal (M) comprising a proportion (y) of oxygen such that the second oxide (MOy) is electrically conductive, with an electrical conductivity greater than 100 Siemens per metre.

10. Method according to claim 9, wherein the step (St31) of producing the reservoir layer (55; 65) comprises the following sub-steps:
- (St310) depositing a layer (35) of said metal (M) on the active layer (54; 64), then
- (St311) carrying out an annealing at a temperature and for a duration such that the previously deposited layer includes, after annealing: said upper part (551; 651) made of said metal (M), as well as said lower part (552; 652) made of the electrically conductive second oxide (MOy).

11. Method according to claim 9, wherein the step (St31') of producing the reservoir layer (85) comprises the following sub-steps:
- (St310') depositing a first sub-layer (852) on the active layer (84), the first sub-layer (852) being made of the second oxide (MOy), then
- (St311') depositing a second sub-layer (851) on the first sub-layer (852), the second sub-layer (851) being made of said metal (M).

12. Method according to claim 11 wherein the sub-step (310') of depositing the first sub-layer (852) is carried out:
- by cathodic sputtering from a target made of said electrically conductive second oxide (MOy), or by
- cathodic sputtering from a target made of said metal (M), under an atmosphere comprising oxygen, the oxygen partial pressure in said atmosphere being such that the first sub-layer (852) deposited is made of said second oxide (MOy), with said proportion (y) in oxygen.

13. Method according to any of claims 9 to 12, wherein the step of etching (St33) is a halogenated plasma etching.
